# EUROPEAN PATENT APPLICATION

(11) **EP 3 664 127 A2**
(43) Date of publication of application: **10.06.2020**
(21) Application number: 19214167.9
(22) Date of filing: 06.12.2019
(51) Int. Cl.: H01L 21/56, H01L 23/29, H01L 21/60

(54) **SEMICONDUCTOR PACKAGE HAVING A LASER-ACTIVATABLE MOLD COMPOUND**

(30) Priority: 07.12.2018 US 201816213593
(71) Applicant: Infineon Technologies AG, 85579 Neubiberg (DE)
(72) Inventor: Chiang, Chau Fatt, 76450 Melaka (MY); Reiss, Werner, 83064 Raubling (DE); Schmalzl, Stefan Helmut, 82054 Sauerlach (DE)
(74) Representative: König, Andreas Rudolf

(57) **Abstract**

Embodiments of molded packages and corresponding methods of manufacture are provided. In an embodiment of a molded package, the molded package includes a laser-activatable mold compound (102) having a plurality of laser-activated regions which are plated with an electrically conductive material to form metal pads (106) and/or metal traces (107) at a first side of the laser-activatable mold compound. A semiconductor die (108) embedded in the laser-activatable mold compound has a plurality of die pads (110). An interconnect (112) electrically connects the plurality of die pads of the semiconductor die to the metal pads and/or metal traces at the first side of the laser-activatable mold compound.

## Description

### BACKGROUND

Many types of semiconductor devices are highly sensitive to parasitic electrical effects such as parasitic interconnect resistance and inductance, parasitic capacitive coupling, etc. For example, switches, RF (radio frequency) power amplifiers, low-noise amplifiers (LNAs), antenna tuners, mixers, etc. are each highly sensitive to parasitic electrical effects. Techniques for reducing parasitic electrical effects on a packaged semiconductor device often result in higher overall cost, larger package size, more complex manufacturing process, reduced device performance, etc.

Thus, there is a need for an improved low parasitic package for semiconductor devices.

### SUMMARY

According to an embodiment of a molded package, the molded package comprises: a laser-activatable mold compound having a plurality of laser-activated regions which are plated with an electrically conductive material to form metal pads and/or metal traces at a first side of the laser-activatable mold compound; a semiconductor die embedded in the laser-activatable mold compound and having a plurality of die pads; and an interconnect electrically connecting the plurality of die pads of the semiconductor die to the metal pads and/or metal traces at the first side of the laser-activatable mold compound.

In one embodiment, the interconnect comprises a plurality of wire stud bumps attached at a first end to the plurality of die pads of the semiconductor die and attached at a second end opposite the first end to the metal pads and/or metal traces at the first side of the laser-activatable mold compound.

In another embodiment, the interconnect comprises a plurality of metal pillars attached at a first end to the plurality of die pads of the semiconductor die and attached at a second end opposite the first end to the metal pads and/or metal traces at the first side of the laser-activatable mold compound.

In another embodiment, the interconnect comprises a plurality of vertical bond wires attached at a first end to the plurality of die pads of the semiconductor die and attached at a second end opposite the first end to the metal pads and/or metal traces at the first side of the laser-activatable mold compound.

Separately or in combination, the molded package may further comprise a solder resist layer covering a portion of the first side of the laser-activatable mold compound so that at the first side only part of the metal pads and/or metal traces are exposed to form landing pads of the molded package.

Separately or in combination, the plurality of die pads may be disposed at a first side of the semiconductor die, a second side of the semiconductor die opposite the first side may not be covered by the laser-activatable mold compound, and the molded package may further comprise a glob top covering the second side of the semiconductor die.

Separately or in combination, the plurality of die pads may be disposed at a first side of the semiconductor die, a second side of the semiconductor die opposite the first side may not be covered by the laser-activatable mold compound, the laser-activatable mold compound may be thicker than the semiconductor die, and the laser-activatable mold compound may have a recessed region at the second side of the semiconductor die.

The recessed region of the laser-activatable mold compound may form an open cavity within the molded package.

Separately or in combination, the molded package may further comprise a heat sink disposed in the recessed region of the laser-activatable mold compound.

Separately or in combination, the metal pads and/or metal traces at the first side of the laser-activatable mold compound may be about 1 µm to about 80 µm thick, e.g. about 5 µm to about 20 µm thick.

Separately or in combination, the semiconductor die may include an RF front end circuit, logic devices or may be a controller.

Separately or in combination, a first one of the metal pads at the first side of the laser-activatable mold compound may be electrically connected to a first one of the die pads of the semiconductor die by the interconnect, and in a vertical projection of a footprint of the first die pad onto the first side of the laser-activatable mold compound, the first metal pad may be positioned outside the footprint of the first die pad.

The first metal pad may be connected to a first one of the metal traces at the first side of the laser-activatable mold compound, and in the vertical projection, the first metal traces may be positioned inside the footprint of the first die pad and vertically aligned with the first die pad.

According to an embodiment of a method of manufacturing a molded package, the method comprises: placing a semiconductor die on a carrier, the semiconductor die having a plurality of die pads facing away from the carrier; attaching an interconnect to the plurality of die pads of the semiconductor die before or after placing the semiconductor die on the carrier; embedding the semiconductor die and the interconnect in a laser-activatable mold compound; directing a laser at a first side of the laser-activatable mold compound to laser-activate a plurality of regions of the laser-activatable mold compound; and plating an electrically conductive material on the plurality of laser-activated regions of the laser-activatable mold compound to form metal pads and/or metal traces at the first side of the laser-activatable mold compound, wherein the interconnect electrically connects the plurality of die pads of the semiconductor die to the metal pads and/or metal traces at the first side of the laser-activatable mold compound.

In one embodiment, attaching the interconnect to the plurality of die pads of the semiconductor die comprises attaching a plurality of wire stud bumps to the plurality of die pads of the semiconductor die.

In another embodiment, attaching the interconnect to the plurality of die pads of the semiconductor die comprises attaching a plurality of metal pillars to the plurality of die pads of the semiconductor die.

In another embodiment, attaching the interconnect to the plurality of die pads of the semiconductor die comprises attaching a plurality of vertical bond wires attached at a first end to the plurality of die pads of the semiconductor die.

Separately or in combination, the method may further comprise covering a portion of the first side of the laser-activatable mold compound with a solder resist layer so that at the first side only part of the metal pads and/or metal traces are exposed to form landing pads of the molded package.

Separately or in combination, the method may further comprise: after plating the electrically conductive material on the plurality of laser-activated regions of the laser-activatable mold compound, removing the carrier from the semiconductor die to expose a side of the semiconductor die opposite the die pads; and covering the side of the semiconductor die exposed by removing the carrier with a glob top.

Separately or in combination, embedding the semiconductor die and the interconnect in the laser-activatable mold compound may comprise covering the interconnect with the laser-activatable mold compound at a side of the interconnect facing away from the carrier, and the method may further comprise thinning (e.g. by grinding) the laser-activatable mold compound to expose the interconnect at the side of the interconnect facing away from the carrier.

Separately or in combination, embedding the semiconductor die and the interconnect in the laser-activatable mold compound may comprise covering the interconnect with the laser-activatable mold compound at a side of the interconnect facing away from the carrier, and the method may further comprise drilling (e.g. by laser or mechanical drilling) holes in the laser-activatable mold compound to expose the interconnect at the side of the interconnect facing away from the carrier.

Separately or in combination, the interconnect may protrude from the laser-activatable mold compound at a side of the interconnect facing away from the carrier after embedding the semiconductor die and the interconnect in the laser-activatable mold compound.

Separately or in combination, the method may further comprise forming a cavity in the laser-activatable mold compound at a side of the semiconductor die opposite the plurality of die pads.

Those skilled in the art will recognize additional features and advantages upon reading the following detailed description, and upon viewing the accompanying drawings.

### BRIEF DESCRIPTION OF THE FIGURES

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.
Figure 1 illustrates a cross-sectional view of an embodiment of a molded package having a laser-activatable mold compound for die (chip) embedding.
Figure 2 illustrates a partial plan view of the molded package of Figure 1.
Figure 3A illustrates a cross-sectional view of an exemplary wire stud bump interconnect which may be used in the molded package of Figure 1.
Figure 3B illustrates a cross-sectional view of an exemplary pillar interconnect which may be used in the molded package of Figure 1.
Figure 3C illustrates a cross-sectional view of an exemplary vertical bond wire interconnect which may be used in the molded package of Figure 1.
Figure 4 illustrates a cross-sectional view of another embodiment of a molded package having a laser-activatable mold compound for die embedding.
Figures 5A through 5E illustrate respective partial cross-sectional views during different stages of manufacturing molded packages having a laser-activatable mold compound for die embedding, according to an embodiment.
Figures 6A through 6E illustrate respective partial cross-sectional views during different stages of manufacturing molded packages having a laser-activatable mold compound for die embedding, according to another embodiment.
Figures 7A through 7D illustrate respective partial cross-sectional views during different stages of manufacturing molded packages having a laser-activatable mold compound for die embedding, according to yet another embodiment.
Figure 8 illustrates a cross-sectional view of a molded package produced by any one of the methods illustrated in Figures 5A through 5E, Figures 6A through 6E, or Figures 7A through 7D.
Figures 9A through 9E, 10A through 10E, 11A through 11E, and 12A through 12E each illustrate respective partial cross-sectional views during different stages of manufacturing molded packages having a laser-activatable mold compound for die embedding, according to additional embodiments.
Figure 13 illustrates a partial plan view of the structure produced by any one of the methods illustrated in Figures 9A through 9E, 10A through 10E, 11A through 11E, and 12A through 12E, after the plating process and prior to carrier removal.
Figure 14 illustrates a cross-sectional view through one interconnect, one die pad and one metal pad/metal trace produced by any one of the methods illustrated in Figures 9A through 9E, 10A through 10E, 11A through 11E, and 12A through 12E, after the plating process and prior to carrier removal.

### DETAILED DESCRIPTION

The embodiments described herein provide molded semiconductor packages with low parasitics, and corresponding methods of manufacture. The packages use a laser-activatable mold compound for die (chip) embedding. The laser-activatable mold compound includes at least one additive e.g. in the form of an organic metal complex which is activated by a physio-chemical reaction induced by a focused laser beam. The reaction cracks open the complex compounds in the mold compound and breaks off metal atoms from the organic ligands. The freed metal atoms act as nuclei for metal or metal alloy (e.g. Cu, Ni, NiP, Au, Cu / Ni / Au stack, etc.) coating/plating in regions of the mold compound activated by a laser. The term "laser-activated regions" as used herein mean regions of the laser-activatable mold compound which have already been activated by a laser beam, as opposed to a laser-activatable region of the mold compound which is capable of being activated by laser light but has yet to actually be activated. The laser-activated regions of the mold compound are plated with an electrically conductive material to form metal pads and/or metal traces at one or more sides of the laser-activatable mold compound. Hence, the metal pads and/or metal traces are structured directly on the mold compound without having to use a sophisticated and expensive lead frame. Accordingly, the distance between the active circuit and the package I/O (inputs/outputs) is controllable to minimize parasitic electric effects. Also, the metal pads and/or metal traces which may be realized with this approach yield greater design freedom in that the die interconnect (e.g. wire stud bumps, metal pillars, vertical bond wires, etc.) are not required to necessarily reside inside the footprint of a die pad as is the case with a leadframe-type approach. It is to be understood that the features of the various embodiments described herein may be combined with each other, unless specifically noted otherwise.

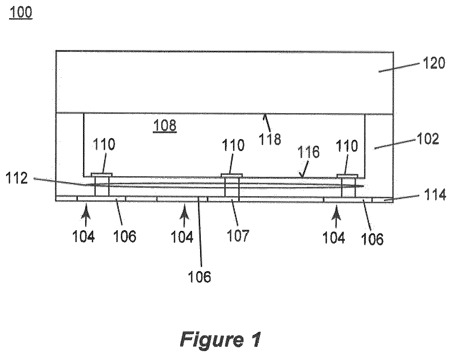

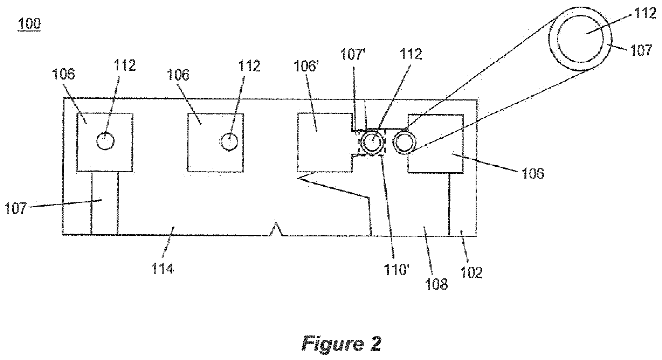

Figure 1 illustrates a cross-sectional view of an embodiment of a molded package 100, and Figure 2 illustrates a partial plan view of the molded package 100. The molded package 100 includes a laser-activatable mold compound 102 having a plurality of laser-activated regions 104 which are plated with an electrically conductive material to form metal pads 106 and/or metal traces 107 at one or more sides of the laser-activatable mold compound 102. At least one semiconductor die 108 is embedded in the laser-activatable mold compound 102 and has a plurality of die pads 110. For example, only one semiconductor die 108 may be embedded in the laser-activatable mold compound 102, or two or more semiconductor dies 108 may be embedded in the laser-activatable mold compound 102. The number and type of semiconductor dies 108 embedded in the laser-activatable mold compound 102 depends on various factors, and should not be considered limiting. For example, one or more semiconductor dies 108 embedded in the laser-activatable mold compound 102 may include an RF front end circuit such as one or more power switches, an RF power amplifier, an LNA, an antenna tuner, a mixer, etc. In addition or alternatively, one or more semiconductor dies 108 embedded in the laser-activatable mold compound 102 may include logic devices. In addition or alternatively, one of the semiconductor dies 108 embedded in the laser-activatable mold compound 102 may be a controller. Again, the number and type of semiconductor dies 108 embedded in the laser-activatable mold compound 102 depends on various factors should not be considered limiting.

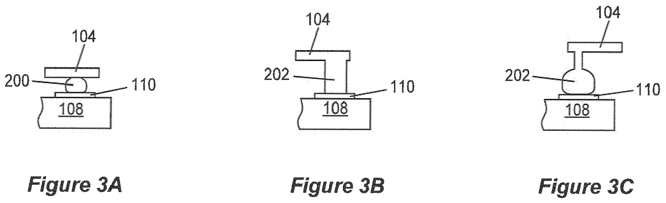

The molded package 100 also includes an interconnect 112 for connecting the die pads 110 of each embedded semiconductor die 108 to corresponding ones of the metal pads 106 and/or metal traces 107 formed at one or more sides of the laser-activatable mold compound 102. Any type of interconnect 112 may be used. For example, the interconnect 112 may include wire stud bumps made of a metal such as copper, gold, aluminium, nickel, etc. or a metal alloy attached at a first end to the die pads 110 and attached at a second end opposite the first end to the metal pads 106 and/or metal traces 107. An exemplary wire stud bump 200 is shown in Figure 3A. In another embodiment, the interconnect 112 includes metal pillars made of a metal such as copper, gold, aluminium, nickel, etc. or a metal alloy attached at a first end to the die pads 110 and attached at a second end opposite the first end to the metal pads 106 and/or metal traces 107. An exemplary pillar 202 is shown in Figure 3B. In yet another embodiment, the interconnect 112 includes vertical bond wires attached at a first end to the die pads 110 and attached at a second end opposite the first end to the metal pads 106 and/or metal traces 107. The second (distal) end is formed by cutting the bond wire after the first (proximal) end is bonded to the corresponding die pad 110. Bond wires tend to be thinner than wire stud bumps and metal pillars, resulting is less capacitive coupling between neighboring pads. Also, larger lengths are possible, allowing for more distance between the the metal pads and/or metal traces and the semiconductor die. An exemplary vertical bond wire 204 is shown in Figure 3C. The laser-activatable mold compound 102 is not shown in Figures 3A through 3C for ease of illustration of the respective interconnect structures 200, 202, 204. Still other types of interconnects may be used, e.g., such as solder bumps.

The molded package 100 may also include a solder resist layer 114 such as a lacquer, epoxy, liquid photoimageable solder mask, dry-film photoimageable solder mask, etc. which covers a portion of the side of the laser-activatable mold compound 102 with the metal pads 106 and/or metal traces 107, so that only part of the metal pads 106 and/or metal traces 107 are exposed at that side to form landing pads of the molded package 100. External connections may be made to the landing pads of the molded package 100, e.g., by soldering to a printed circuit board (PCB), another molded package, etc.

In one embodiment, the die pads 110 are disposed at one side 116 of the semiconductor die and a second side 118 of the die 108 opposite the first side 116 is not covered by the laser-activatable mold compound 102. The molded package 100 may instead further include a glob top or other type of protective material 120 covering the second side 118 of the semiconductor die 108. In the case of a glob top, the glob top serves as an encapsulation which protects the semiconductor die 108. A glob top may be placed over the semiconductor die 108 as an environmental barrier, mechanical reinforcement, tamper proof layer, etc. There are two main types of glob tops: single material hemispherical and two material dam-and-fill. In other embodiments, the second side 118 of the semiconductor die 108 may or may not have die pads 110 and is at least partly covered by the laser-activatable mold compound 102.

As previously described herein, the metal pads 106 and/or metal traces 107 formed at one or more sides of the laser-activatable mold compound 102 are not necessarily required to reside inside the die pad footprint. For example, a first one 106' of the metal pads 106 may be electrically connected to a first one 110' of the die pads 110 by the interconnect 112. The first die pad 110' is illustrated as a dashed box in Figure 2 since the first die pad 110' is covered and therefore out of view. The solder resist layer 114 is shown partially removed in Figure 2, to illustrate part of the laser-activatable mold compound 102 and part of the semiconductor die 108 having the first die pad 110' mentioned above. In a vertical projection (coming out of the page in Figure 2) of the footprint of the first die pad 110' onto the side of the laser-activatable mold compound 102 with the first metal pad 106', the first metal pad 106' may be positioned outside the footprint of the first die pad 110'. The same first metal pad 106' may be connected to a first one 107' of the metal traces 107 at the same side of the laser-activatable mold compound 102 as the first metal pad 106'. In the vertical projection, the first metal trace 107' may be positioned at least partly inside the footprint of the first die pad 110' and therefore vertically aligned with the first die pad 110'.

The size, shape and layout of the metal pads 106 and/or metal traces 107 formed at one or more sides of the laser-activatable mold compound 102 depends on various factors and should not be considered limiting. For example, in the case of an RF package, the thickness of the metal pads 106 and/or metal traces 107 may range from about 10 µm (microns) to about 15 µm. The metal pads 106 and/or metal traces 107 may be even thinner, e.g., in the range of about 5 µm to about 10 µm. For high power applications, the thickness of the metal pads 106 and/or metal traces 107 may be even greater, e.g., about 20 µm to about 40 µm or even thicker. For example, the metal pads 106 and/or metal traces 107 may have a thickness of about 1µm to about 80 µm. Thicker metal pads 106 and/or metal traces 107 may be preferred in view of ohmic losses, whereas thinner metal pads 106 and/or metal traces 107 may be preferred to keep the capacitance low. For an RF application that does not involve power conversion, the skin effect limits the usefulness of thicker metal pads 106 and/or metal traces 107. The positioning of the metal pads 106 and/or metal traces 107 relative to the die pads 110 also depends on various factors and should not be considered limiting.

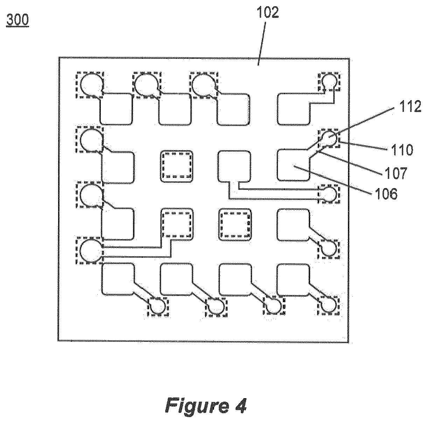

Figure 4 illustrates a plan view of another embodiment of a molded package 300 having the laser-activatable mold compound 102, at least one semiconductor die (out of view) embedded in the laser-activatable mold compound 102, and an interconnect 112 connecting die pads 110 of the semiconductor die to the metal pads 106 and/or metal traces 107 at one or more sides of the laser-activatable mold compound 102. According to this embodiment, some of the metal pads 106 and metal traces 107 reside entirely or partly inside the footprint of the respective die pads 110 and other ones of the metal pads 106 and metal traces 107 reside outside the footprint of the respective die pads 110 in a vertical projection (coming out of the page in Figure 4) of the molded package 300. The die pads 110 are illustrated as dashed boxes in Figure 4 since the die pads 110 are out of view. Only a single instance of a die pad 110, interconnect 112, metal pad 106 and metal trace 107 are labelled in Figure 4 to reduce obfuscation of the drawing and aid in understanding. The metal pads 106 have a generally square shape, the metal traces 107 have a generally rectangular shape, and the interconnect 112 has a generally circular shape to clearly distinguish between these different elements of the molded package 300. Again, the size, shape, layout and positioning of the metal pads 106 and/or metal traces 107 formed at one or more sides of the laser-activatable mold compound 102 depends on various factors and should not be considered limiting. The size, shape and layout of the interconnect 112 also depends on various factors including interconnect type (e.g. wire stud bumps, metal pillars, vertical bond wires, etc.), and therefore should not be considered limiting.

Described next are various method embodiments for manufacturing a molded package having the laser-activatable mold compound and interconnect features described herein.

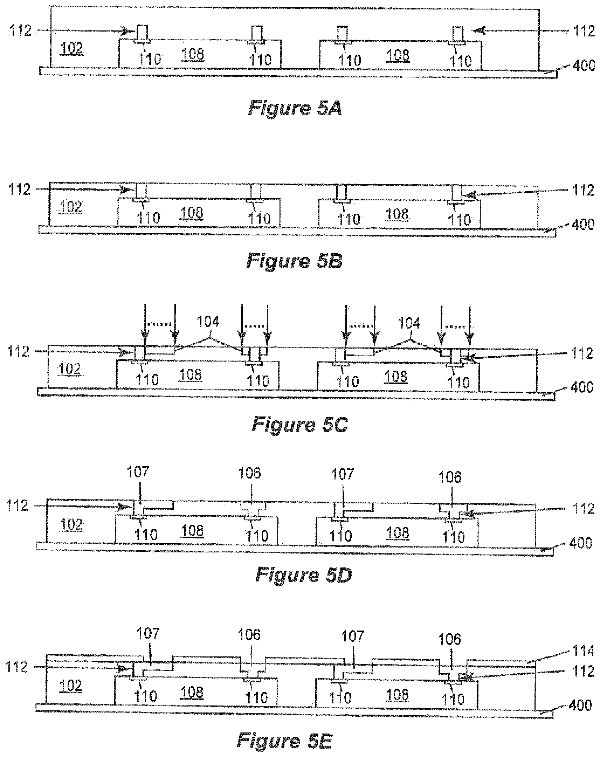

Figures 5A through 5E illustrate respective partial cross-sectional views during different stages of manufacturing the molded packages described herein, according to an embodiment.

Figure 5A shows a plurality of semiconductor dies 108 attached to a temporary carrier 400 such as a metal plate, plastic plate or film, foil, tape, etc., with interconnects 112 facing away from the carrier 400. The semiconductor dies 108 may be attached to the carrier 400 using a glue or a double-sided tape, for example, via a single unit placement process. In another embodiment, the semiconductor dies 108 may be attached to the carrier 400 by first attaching the dies 108 to a wafer (not shown) and laminating the wafer to the carrier 400.

Each interconnect 112 may include wire stud bumps, metal pillars, vertical bond wires, etc., as previously described herein. The semiconductor dies 108 were singulated from a semiconductor wafer (not shown), e.g. by sawing, prior to being attached to the carrier 400. In general, the semiconductor wafer and therefore the resulting semiconductor dies 108 may be made of any semiconductor material suitable for manufacturing a semiconductor device. Examples of such materials include, but are not limited to, elementary semiconductor materials such as silicon (Si) or germanium (Ge), group IV compound semiconductor materials such as silicon carbide (SiC) or silicon germanium (SiGe), binary, ternary or quaternary III-V semiconductor materials such as gallium nitride (GaN), gallium arsenide (GaAs), gallium phosphide (GaP), indium phosphide (InP), indium gallium phosphide (InGaPa), aluminum gallium nitride (AIGaN), aluminum indium nitride (AlInN), indium gallium nitride (InGaN), aluminum gallium indium nitride (AlGaInN) or indium gallium arsenide phosphide (InGaAsP), etc.

The semiconductor dies 108 are embedded in a laser-activatable mold compound 102 of the kind previously described herein, after the dies 110 are attached to the carrier 400. According to this embodiment, the semiconductor dies 110 are over-molded in that the side of the dies 108 with the interconnects 112 is covered by an appreciable amount of the laser-activatable mold compound 102, meaning that the mold compound 102 will have to be thinned to expose the interconnects 112.

Figure 5B shows the structure after the laser-activatable mold compound 102 is thinned to exposed the interconnects 112 connected to the die pads 110 of the semiconductor dies 108. In one embodiment, the laser-activatable mold compound 102 is thinned by grinding until the interconnects 112 are exposed.

Figure 5C shows the structure during laser activation of different regions of the laser-activatable mold compound 102. The downward-facing arrows indicate a laser being directed at the side of the laser-activatable mold compound 102 with the exposed interconnects 112, thereby laser activating different of regions 104 of the mold compound 102. As previously described herein, metal atoms freed by laser activation act as nuclei metal or metal alloy (e.g. Cu, Ni, NiP, Au, Cu / Ni / Au stack, etc.) coating/plating in regions 104 of the mold compound 102 defined by the laser. Suitable polymers for such laser direct structuring of the laser-activatable mold compound 102 may include, but are not limited to, thermoset polymers having a resin base, ABS (acrylonitrile butadiene styrene), PC/ABS (polycarbonate / acrylonitrile butadiene styrene), PC (polycarbonate), PA/PPA (polyimide / polyphthalamide), PBT (polybutylene terephthalate), COP (cyclic olefin polymer), PPE (polyphenyl ether), LCP (liquid-crystal polymer), PEI (polyethylenimine or polyaziridine), PEEK (polyether ether ketone), PPS (polyphenylene sulfide), etc.

Figure 5D shows the structure after plating an electrically conductive material on the plurality of laser-activated regions 104 of the laser-activatable mold compound 102 to form metal pads 106 and/or metal traces 107 at the side of the laser-activatable mold compound 102 with the exposed interconnects 112. Each interconnect 112 electrically connects the corresponding die pads 110 to the corresponding metal pads 106 and/or metal traces 107 for that molded package. The plating process may begin with a cleaning step to remove laser debris and may be followed by an additive build-up of plated metal, metal alloy or metal stack to form the metal pads 106 and/or metal traces 107, e.g., using a current-free Cu bath in the case of Cu metal pads 106 and/or metal traces 107. If greater thickness of copper is required, a standard electroforming Cu bath may be used. One or more application-specific coatings such as Ni, Au, Sn, Sn/Pb, Ag, Ag/Pd, etc., may also be applied to the metal pads 106 and/or metal traces 107.

Figure 5E shows the structure after covering a portion of the side of the laser-activatable mold compound 102 having the metal pads 106 and/or metal traces 107 with a solder resist layer 114, so that only part of the metal pads 106 and/or metal traces 107 are exposed to form landing pads of each molded package. The solder resist layer 114 may be a lacquer, epoxy, liquid photoimageable solder mask, dry-film photoimageable solder mask, etc. The structure may then be re-laminated to another carrier (not shown) with the landing pads facing the new carrier, and the old carrier may be removed. The structure may then be thinned at the side from which the original carrier was removed, e.g. by grinding. A glob top may be applied to this side of the structure, protecting the exposed side of each semiconductor die 108. Individual molded packages are then singulated, e.g., by sawing through the structure between adjacent packages.

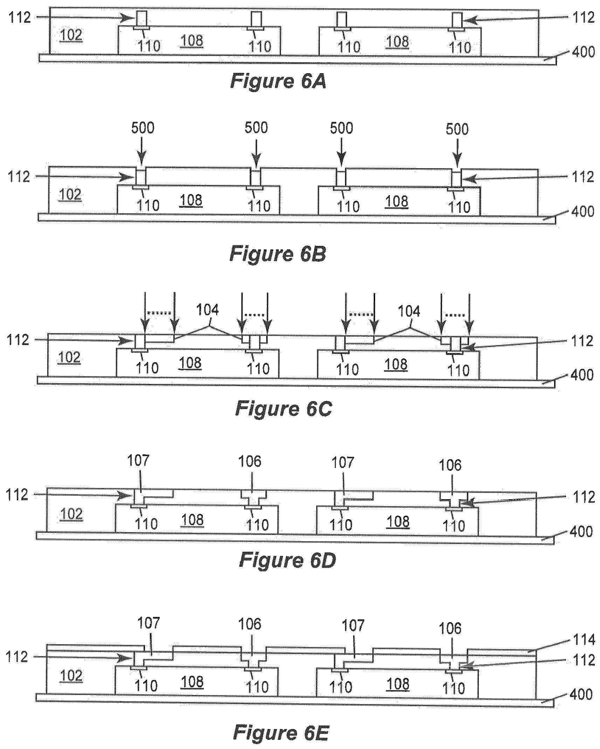

Figures 6A through 6E illustrate respective partial cross-sectional views during different stages of manufacturing the molded packages described herein, according to another embodiment. The embodiment shown in Figures 6A through 6E is similar to the embodiment shown in Figures 5A through 5E. Different, however, in Figure 6A the semiconductor dies 108 are only slightly over-molded by an inappreciable amount of the laser-activatable mold compound 102, e.g. by about 5 µm to about 20 µm, meaning that the interconnects 112 may be exposed by drilling (e.g. by laser or mechanical drilling) of the mold compound 102 instead of grinding. Figure 6B shows the structure after the drilling process, which forms holes (openings) 500 in the laser-activatable mold compound 102 to expose the interconnects 112. Figures 6C through 6E are identical to Figures 5C through 5E, respectively.

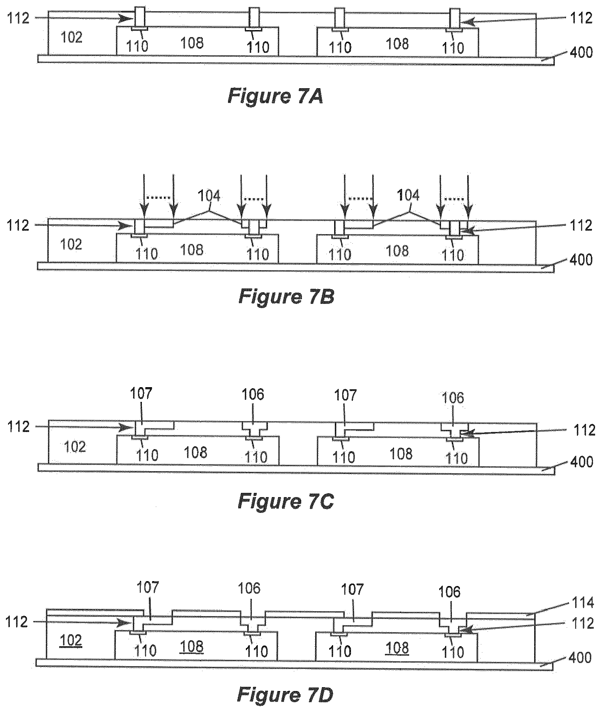

Figures 7A through 7D illustrate respective partial cross-sectional views during different stages of manufacturing the molded packages described herein, according to yet another embodiment. The embodiment shown in Figures 7A through 7D is similar to the embodiment shown in Figures 5A through 5E. Different, however, in Figure 7A the interconnects 112 protrude from the laser-activatable mold compound 102 at the side of the interconnects 112 facing away from the carrier 400 after embedding the semiconductor dies 108 and the interconnects 112 in the laser-activatable mold compound 102. For example, a rubber element may be placed in the jig used to mold the structure. The rubber element prevents the laser-activatable mold compound 102 from fully encasing the interconnects 112. This way, thinning (e.g. by grinding) or drilling (e.g. by laser or mechanical drilling) of the laser-activatable mold compound 102 to expose the interconnects 112 may be avoided. The interconnects 112 may be thinned, e.g., by grinding after the molding process, so that the interconnects 112 and the side of the laser-activatable mold compound 102 at which the interconnects 112 terminate are generally planar. Figures 7B through 7D are identical to Figures 5C through 5E, respectively.

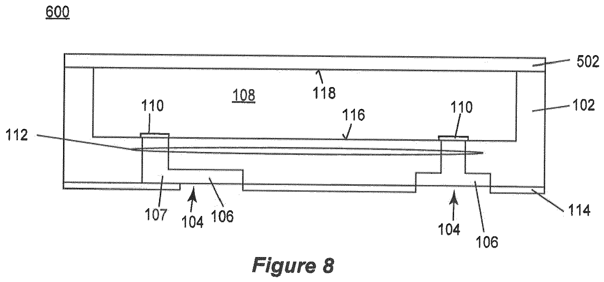

Figure 8 illustrates a cross-sectional view of a molded package 600 produced by any one of the methods illustrated in Figures 5A through 5E, Figures 6A through 6E, or Figures 7A through 7D. A glob top 502 covers the backside 118 of the semiconductor die 108, which may or may not have been thinned prior to application of the glob top 120. An element other than a glob top may adjoin the backside 118 of the semiconductor die 108. For example, a heat sink (not shown) may be attached to the exposed backside 118 of the semiconductor die 108, or a cavity may be formed in the laser-activatable mold compound 102 at the die backside 118.

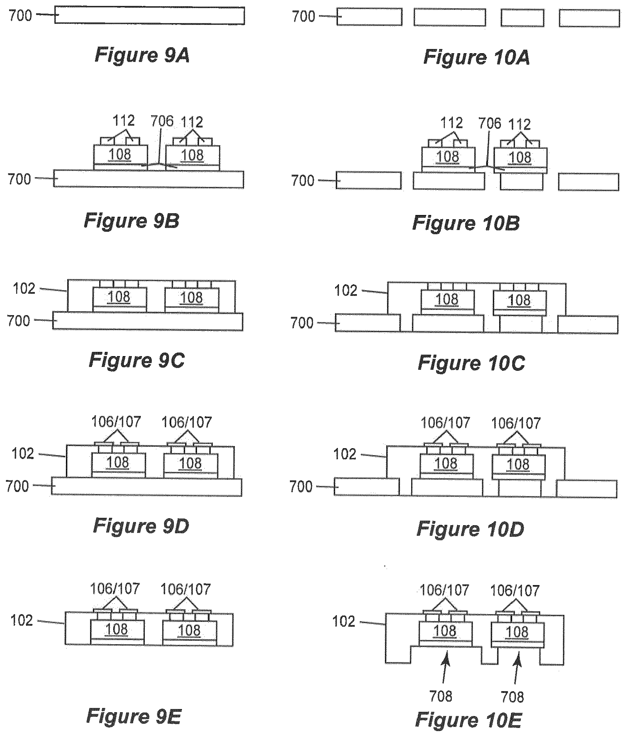

Figures 9A through 9E, 10A through 10E, 11A through 11E, and 12A through 12E each illustrate respective partial cross-sectional views during different stages of manufacturing the molded packages described herein, according to additional embodiments.

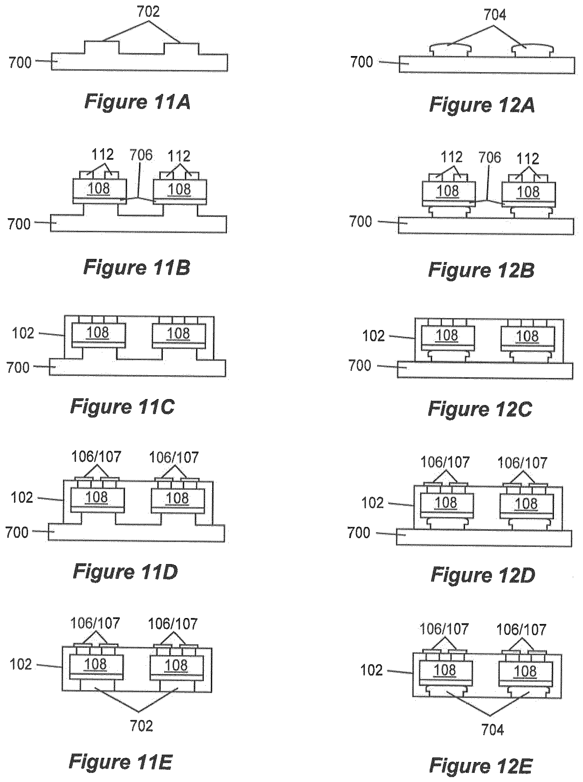

In Figures 9A, 10A, 11A, and 12A, a carrier 700 such as a metal plate, plastic plate or film, foil, tape, etc. is provided. In Figure 9A, the carrier 700 is unstructured prior to die attach. In Figure 10A, the carrier 700 is structured prior to die attach. In Figure 11A, the carrier 700 has standoffs 702. In Figure 12A, a spacer material 704 is applied to the carrier 700 prior to die attach. The spacer material 704 allows for a certain insulating distance at the backside of the dies. The spacer material 704 may be removed later to form a cavity, e.g. in the case of a MEMS (Microelectromechanical systems) or sensor application, or to be replaced with a heat sink at the backside of the dies. The spacer material 704 also provides a buffer so that the dies do not come into contact with chemicals subsequently used to remove the carrier.

Figures 9B, 10B, 11B and 12B show the respective carriers after attachment of the semiconductor dies 108 using a die attach material 706 such as solder, adhesive tape, glue, etc. In the case of Figure 12B, the spacer material 704 may serve as the die attach material.

Figures 9C, 10C, 11C and 12C show the respective structures after molding of the semiconductor dies 108 with the laser-activatable mold compound 102, and may correspond to any of the embodiments previously described herein in connection with Figures 5A-5B, 6A-6B and 7A. That is, the die interconnects 112 may be exposed by thinning (e.g. by grinding) of the laser-activatable mold compound 102 (e.g. Figure 5B), drilling (e.g. by laser or mechanical drilling) of the laser-activatable mold compound 102 (e.g. Figure 6B), or by modifying the molding jig so that the interconnects 112 protrude from the laser-activatable mold compound 102 without having to thin or laser drill the mold compound 102 (e.g. Figure 7A).

Figures 9D, 10D, 11D and 12D show the respective structures after laser-activating different regions of the laser-activatable mold compound and plating an electrically conductive material on the laser-activated regions of the laser-activatable mold compound to form metal pads 106 and/or metal traces 107, and may correspond to any of the embodiments previously described herein in connection with Figures 5C-5D, 6C-6D and 7B-7C.

Figures 9E, 10E, 11E and 12E show the respective structures after removal of the carrier 700. In the case of Figure 9E, the backside of the semiconductor dies 108 or the die attach material 706 at the die backsides (if not removed) is exposed and generally planar with the backside of the laser-activatable mold compound 102. In the case of Figure 10E, the die pads (not shown) are disposed at a first side of each die 108, the (opposite) second side of each die 108 is not covered by the laser-activatable mold compound 102, the laser-activatable mold compound 102 is thicker than the semiconductor dies 108, and the laser-activatable mold compound 102 has a recessed region 708 at the second side of the semiconductor dies 108 which is formed by removing the structured carrier 700. The recessed regions 708 may be filled with a heat sink material or may remain unfilled to form a cavity, e.g. in the case of a MEMS or sensor application. In the case of Figure 11E, the laser-activatable mold compound 102 contacts the backside of the dies 108 around a periphery of the dies 108 due to the use of the standoffs 702. The standoffs 702 may remain in the final molded packages, or may be removed, e.g., to form respective cavities. In the case of Figure 12E, the spacer material 704 may remain in the final molded packages or may be removed, e.g., to form a respective cavities.

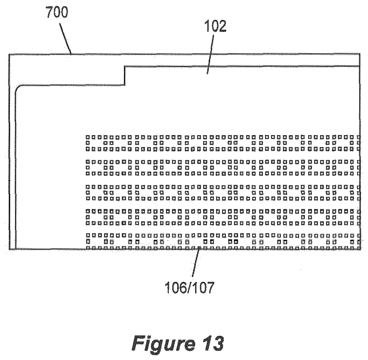

Figure 13 illustrates a partial plan view of the structure produced by any one of the methods illustrated in Figures 9A through 9E, 10A through 10E, 11A through 11E, and 12A through 12E, after the plating process and prior to carrier removal. The metal pads 106 and/or metal traces 107 are visible for several packages prior to singulation. Only a single instance of a metal pad 106 / metal trace 107 is labelled in Figure 13 to reduce obfuscation of the drawing and aid in understanding.

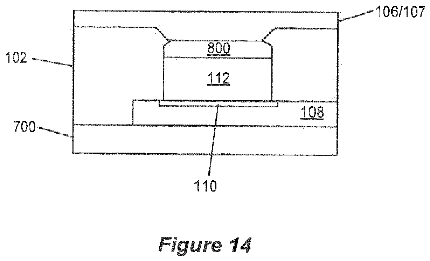

Figure 14 illustrates a cross-sectional view through one interconnect 112, one die pad 110 and one metal pad/metal trace 106/107 produced by any one of the methods illustrated in Figures 9A through 9E, 10A through 10E, 11A through 11E, and 12A through 12E, after the plating process and prior to carrier removal. One or more application-specific coatings 800 such as Ni, Au, Sn, Sn/Pb, Ag, Ag/Pd, etc., may be applied to the interconnect 112 as shown in Figure 14.

Terms such as "first", "second", and the like, are used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A molded package, comprising:
a laser-activatable mold compound having a plurality of laser-activated regions which are plated with an electrically conductive material to form metal pads and/or metal traces at a first side of the laser-activatable mold compound;
a semiconductor die embedded in the laser-activatable mold compound and having a plurality of die pads; and
an interconnect electrically connecting the plurality of die pads of the semiconductor die to the metal pads and/or metal traces at the first side of the laser-activatable mold compound.

2. The molded package of claim 1, wherein the interconnect comprises at least one of:
a plurality of wire stud bumps attached at a first end to the plurality of die pads of the semiconductor die and attached at a second end opposite the first end to the metal pads and/or metal traces at the first side of the laser-activatable mold compound;
a plurality of metal pillars attached at a first end to the plurality of die pads of the semiconductor die and attached at a second end opposite the first end to the metal pads and/or metal traces at the first side of the laser-activatable mold compound; or
a plurality of vertical bond wires attached at a first end to the plurality of die pads of the semiconductor die and attached at a second end opposite the first end to the metal pads and/or metal traces at the first side of the laser-activatable mold compound.

3. The molded package of claim 1 or 2, further comprising a solder resist layer covering a portion of the first side of the laser-activatable mold compound so that at the first side only part of the metal pads and/or metal traces are exposed to form landing pads of the molded package.

4. The molded package of one of claims 1 to 3, wherein the plurality of die pads is disposed at a first side of the semiconductor die, wherein a second side of the semiconductor die opposite the first side is not covered by the laser-activatable mold compound, and wherein the molded package further comprises a glob top covering the second side of the semiconductor die.

5. The molded package of one of claims 1 to 4, wherein the plurality of die pads is disposed at a first side of the semiconductor die, wherein a second side of the semiconductor die opposite the first side is not covered by the laser-activatable mold compound, wherein the laser-activatable mold compound is thicker than the semiconductor die, and wherein the laser-activatable mold compound has a recessed region at the second side of the semiconductor die.

6. The molded package of claim 5, wherein the recessed region of the laser-activatable mold compound forms an open cavity within the molded package and/or comprising a heat sink disposed in the recessed region of the laser-activatable mold compound.

7. The molded package of one of claims 1 to 6, wherein the metal pads and/or metal traces at the first side of the laser-activatable mold compound are about 1 µm to about 80 µm thick.

8. The molded package of one of claims 1 to 7, wherein a first one of the metal pads at the first side of the laser-activatable mold compound is electrically connected to a first one of the die pads of the semiconductor die by the interconnect, and wherein in a vertical projection of a footprint of the first die pad onto the first side of the laser-activatable mold compound, the first metal pad is positioned outside the footprint of the first die pad.

9. The molded package of claim 8, wherein the first metal pad is connected to a first one of the metal traces at the first side of the laser-activatable mold compound, and wherein in the vertical projection, the first metal trace is positioned inside the footprint of the first die pad and vertically aligned with the first die pad.

10. A method of manufacturing a molded package, the method comprising:
placing a semiconductor die on a carrier, the semiconductor die having a plurality of die pads facing away from the carrier;
attaching an interconnect to the plurality of die pads of the semiconductor die before or after placing the semiconductor die on the carrier;
embedding the semiconductor die and the interconnect in a laser-activatable mold compound;
directing a laser at a first side of the laser-activatable mold compound to laser-activate a plurality of regions of the laser-activatable mold compound; and
plating an electrically conductive material on the plurality of laser-activated regions of the laser-activatable mold compound to form metal pads and/or metal traces at the first side of the laser-activatable mold compound,
wherein the interconnect electrically connects the plurality of die pads of the semiconductor die to the metal pads and/or metal traces at the first side of the laser-activatable mold compound.

11. The method of claim 10, wherein attaching the interconnect to the plurality of die pads of the semiconductor die comprises at least one of attaching a plurality of wire stud bumps to the plurality of die pads of the semiconductor die, attaching a plurality of metal pillars to the plurality of die pads of the semiconductor die, orattaching a plurality of vertical bond wires attached at a first end to the plurality of die pads of the semiconductor die.

12. The method of claim 10 or 11, further comprising:
covering a portion of the first side of the laser-activatable mold compound with a solder resist layer so that at the first side only part of the metal pads and/or metal traces are exposed to form landing pads of the molded package.

13. The method of one of claims 10 to 12, further comprising:
after plating the electrically conductive material on the plurality of laser-activated regions of the laser-activatable mold compound, removing the carrier from the semiconductor die to expose a side of the semiconductor die opposite the die pads; and
covering the side of the semiconductor die exposed by removing the carrier with a glob top.

14. The method of one of claims 10 to 13, wherein embedding the semiconductor die and the interconnect in the laser-activatable mold compound comprises covering the interconnect with the laser-activatable mold compound at a side of the interconnect facing away from the carrier, the method further comprising:
thinning the laser-activatable mold compound to expose the interconnect at the side of the interconnect facing away from the carrier, or
drilling holes in the laser-activatable mold compound to expose the interconnect at the side of the interconnect facing away from the carrier.

15. The method of one of claims 10 to 13, wherein the interconnect protrudes from the laser-activatable mold compound at a side of the interconnect facing away from the carrier.
